(19)

Europäisches
Patentamt
European
Patent Office
Office européen
des brevets

(11) **EP 1 859 490 B1**

(12) **EUROPEAN PATENT SPECIFICATION**

(45) Date of publication and mention
of the grant of the patent:
**12.08.2009 Bulletin 2009/33**

(21) Application number: **06710108.9**

(22) Date of filing: **16.03.2006**

(51) Int Cl.:
*H01L 51/00* (2006.01)     *B29C 55/06* (2006.01)
*C08L 67/03* (2006.01)

(86) International application number:
**PCT/GB2006/000946**

(87) International publication number:
**WO 2006/097733 (21.09.2006 Gazette 2006/38)**

(54) **COMPOSITE FILMS SUITABLE FOR USE IN OPTO-ELECTRONIC AND ELECTRONIC DEVICES**

FÜR DIE VERWENDUNG IN OPTOELEKTRONISCHEN UND ELEKTRONISCHEN
EINRICHTUNGEN GEEIGNETE ZUSAMMENGESETZTE FILME

FILMS COMPOSITES APPROPRIES POUR UTILISATION DANS DES DISPOSITIFS
ÉLECTRONIQUES OU OPTOÉLECTRONIQUES

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **17.03.2005 GB 0505517**

(43) Date of publication of application:
**28.11.2007 Bulletin 2007/48**

(60) Divisional application:
**08075641.4 / 1 983 591**
**09075076.1 / 2 058 874**

(73) Proprietor: **DuPont Teijin Films U.S. Limited
Partnership
Chester, VA 23836 (US)**

(72) Inventors:
• **MCDONALD, William, Alasdair
Guisborough TS14 8JX (GB)**
• **PLACIDO, Frank
Renfrewshire (GB)**
• **EVESON, Robert William
Cleveland TS15 9UZ (GB)**

(74) Representative: **Cockerton, Bruce Roger et al
Carpmaels & Ransford
43-45 Bloomsbury Square
London
WC1A 2RA (GB)**

(56) References cited:
**WO-A-03/087247          US-A- 5 858 490
US-A1- 2004 247 916**

• **LEE M J ET AL: "Thin film transistors for displays
on plastic substrates" SOLID STATE
ELECTRONICS, ELSEVIER SCIENCE
PUBLISHERS, BARKING, GB, vol. 44, no. 8,
August 2000 (2000-08), pages 1431-1434,
XP004206765 ISSN: 0038-1101**
• **SERIKAWA T ET AL: "HIGH-MOBILITY POLY-SI
THIN FILM TRANSISTORS FABRICATED ON
STAINLESS-STEEL FOILS BY LOW-
TEMPERATURE PROCESSES USING SPUTTER-
DEPOSITIONS" JAPANESE JOURNAL OF
APPLIED PHYSICS, JAPAN SOCIETY OF
APPLIED PHYSICS, TOKYO, JP, vol. 39, no. 5A,
PART 2, 1 May 2000 (2000-05-01), pages L393-
L395, XP001011902 ISSN: 0021-4922**
• **SARMA K R ET AL: "Active Matrix OLED Using
150 DEG C a-Si TFT Backplane Built on Flexible
Plastic Substrate" PROC SPIE INT SOC OPT ENG;
PROCEEDINGS OF SPIE - THE INTERNATIONAL
SOCIETY FOR OPTICAL ENGINEERING 2003, vol.
5080, 2003, pages 180-191, XP008063097**

Remarks:
The file contains technical information submitted after
the application was filed and not included in this
specification

Note: Within nine months of the publication of the mention of the grant of the European patent in the European Patent
Bulletin, any person may give notice to the European Patent Office of opposition to that patent, in accordance with the
Implementing Regulations. Notice of opposition shall not be deemed to have been filed until the opposition fee has been
paid. (Art. 99(1) European Patent Convention).

**Description**

The present invention relates to a coated polymeric substrate suitable for use as a substrate in flexible electronic and opto-electronic devices, particularly electroluminescent (EL) display devices, in particular organic light emitting display (OLED) devices. The present invention also relates to a process for the production of the coated polymeric substrate.

Electroluminescent (EL) display is a self-emitting display mode which features excellent visibility (including high brightness, high contrast, very fast response speed and wide viewing angle), an extremely thin profile and very low power consumption. The EL display device itself emits light, as do cathode ray tubes (CRT), fluorescent and plasma displays. Unlike liquid crystal displays (LCDs), there is no need for backlighting. The response speed for EL can be as fast as 1000 times that for LCD, thus making this mode particularly well suited for use with moving images. EL displays may be used in a variety of applications, including aircraft and ship controls, automobile audio equipment, calculators, mobile telephones, portable computers, instrumentation, factory monitors and electronic medical equipment. Another major application for EL displays is as a light source, particularly as backlighting for small LCD panels in order to render them easier to read in low ambient light conditions.

EL displays work by sandwiching a thin film of a phosphorescent or other electroluminescent substance between two plates each of which comprises conductive elements in a predetermined pattern, i.e. electrodes, thereby forming addressable pixels on the display. The electrodes are formed as coatings either on the electroluminescent substance or on a separate support. Where the or each electrode is intended to transmit light, the electrodes are formed as translucent or transparent coatings, for instance using transparent conductive metal oxides. Equally, the or each support may be translucent or transparent, as required. Generally, at least the anode is transparent. The support generally functions both as a base for an electrode and as an insulating layer. The substrate also provides protection against chemical and physical damage in use, storage and transportation. Glass, as well as polymeric film, has been used as the insulating support.

EL display devices have utilised a variety of cathode materials. Early investigations employed alkali metals. Other cathode materials include combinations of metals, such as brass and conductive metal oxides (e.g., indium tin oxide). A variety of single metal cathodes, such as indium, silver, tin, lead, magnesium, manganese, and aluminum, have also been used.

Relatively recent discoveries in EL construction include devices wherein the organic luminescent medium consists of two very thin layers (<1.0$\mu$m in combined thickness) separating the anode and cathode. Representative of OLED devices are those disclosed in, for instance US 4720432.

When an electrical current is passed through the conductive elements, the electroluminescent material emits light. EL displays, being an emissive technology, rather than shuttering a light source as per LCD displays, are most useful in applications where high visibility in all light conditions is important.

The development of new, organic electroluminescent materials, which can produce the three primary colours with very high purity, has made possible full-colour displays with uniform levels of brightness and longevity. Polymers and other organic materials having such characteristics can be dissolved in solvents and processed from solution, enabling the printing of electronic devices. Conductive polymeric materials include conjugated polymers and dendritic polymers. Non-polymeric (generally referred to as "small-molecule") organic materials have also been developed for use in EL display devices such as OLEDs, and these typically further comprise transition metal(s). Conductive conjugated polymers are of particular interest. As used herein, the term "conjugated conductive polymer" refers to a polymer having pi-electron delocalisation along its backbone. Polymers of this type are reviewed by W. J. Feast in Polymer, Vol. 37 (22), 5017-5047, 1996. In a preferred embodiment, the conjugated conductive polymer is selected from:

(i) hydrocarbon conjugated polymers, such as polyacetylenes, polyphenylenes and poly(p-phenylene vinylenes);
(ii) conjugated heterocyclic polymers with heteroatoms in the main chain, such as polythiophenes, polypyrroles and polyanilines; and
(iii) conjugated oligomers, such as oligothiophenes, oligopyrroles, oligoanilines, oligophenylenes and oligo(phenylene vinylenes), containing at least two, preferably at least three, preferably at least four, preferably at least five, more preferably 6 or more repeating sub-units.

In addition to use in EL devices, such conductive polymers and other organic materials have been proposed for use in a variety of other electronic and opto-electronic devices, including photovoltaic cells and semiconductor devices (such as organic field effect transistors, thin film transistors and integrated circuits generally).

The present invention concerns the insulating and supporting substrate of an electronic or opto-electronic device typically comprising a conductive polymer, including an EL device (particularly an OLED), a photovoltaic cell and semiconductor devices (such as organic field effect transistors, thin film transistors and integrated circuits generally). The present invention is particularly concerned with the substrate of an opto-electronic device, particularly an EL device (particularly an OLED) or a photovoltaic device, and particularly an EL device (particularly an OLED).

The substrates can be transparent, translucent or opaque, but are typically transparent. The substrates are usually required to meet stringent specifications for optical clarity, flatness and minimal birefringence. Typically, a total light transmission (TLT) of 85% over 400-800 nm coupled with a haze of less than 0.7% is desirable for displays applications. Surface smoothness and flatness are necessary to ensure the integrity of subsequently applied coatings such as the electrode conductive coating. The substrates should also have good barrier properties, i.e. high resistance to gas and solvent permeation. Mechanical properties such as flexibility, impact resistance, hardness and scratch resistance are also important considerations.

Optical quality glass or quartz has previously been used in electronic display applications as substrates. These materials are able to meet the optical and flatness requirements and have good thermal and chemical resistance and barrier properties. However, these materials do not have some of the desired mechanical properties, most notably low density, flexibility and impact resistance. Owing to their more desirable mechanical properties, plastics materials have been proposed as replacements for glass or quartz sheet. Plastic substrates have greater flexibility and improved impact resistance, and are of lighter weight than glass or quartz sheets of equal thickness. In addition, a flexible plastic substrate would allow the printing of electronic devices, for instance using the conductive polymers referred to above, onto the substrate in a reel-to-reel process, which would reduce cost and allow the manufacture of curved-surface devices.

One disadvantage of polymeric materials is their lower chemical resistance and inferior barrier properties. The water vapour transmission rate of a substrate in an opto-electronic device should desirably be less than $10^{-6}$g/m$^2$/day and the oxygen transmission rate should desirably be less than $10^{-5}$/mL/m$^2$/day. No polymeric substrate is capable of meeting this very demanding requirement. Coatings which improve the barrier properties of polymeric films are typically applied in a sputtering process at elevated temperatures. A barrier layer may be organic or inorganic, should exhibit good affinity for the layer deposited thereupon, and be capable of forming a smooth surface. Materials which are suitable for use to form a barrier layer are disclosed, for instance, in US-6,198,217. Typical organic barrier layers include, photocurable monomers or oligomers, or thermoplastic resins. Photocurable monomers or oligomers should have low volatility and high melting points. Examples of such monomers include trimethylol acrylates such as trimethylolpropane triacrylate, ditrimethylolpropane tetraacrylate and the like; long-chain acrylates such as 1,6-hexanediol diacrylate, 1,6-hexanediol dimethacrylate and the like; and cyclohexyl acrylates such as dicyclopentenyloxyethyl acrylate, dicyclopentenyloxy acrylate, cyclohexyl methacrylate and the like. Examples of such oligomers include acrylate oligomers, epoxy acrylate oligomers, urethane acrylate oligomers, ether acrylate oligomers, and the like. Photoinitiators, such as benzoin ethers, benzophenones, acetophenones, ketals and the like, may be used to cure the resin. Examples of suitable thermoplastic resins include polyethylene, polymethyl methacrylate, polyethylene terephthalate and the like. These organic materials are typically applied by vacuum deposition. Typical inorganic barrier layers are made of a material which exhibits low moisture permeability and is stable against moisture. Examples include oxides such as $SiO_2$, $SiO$, $GeO$, $Al_2O_3$, $ZrO_2$ and the like, nitrides such as $TiN$, $Si_3N_4$ and the like, and metals such as Al, Ag, Au, Pt, Ni and the like. The inorganic material is usually applied using a vapour phase technique such as vacuum deposition, sputtering and the like under standard conditions. A barrier layer can itself comprise one or more discrete layers, and may comprise one or more organic layer(s) and one or more inorganic layer(s). Multi-layer arrangements of alternating inorganic and organic layers have been used to increase barrier properties, although the process is complex and costly.

A further disadvantage of polymeric substrates is that they tend to undergo unacceptable dimensional distortion, such as curl, when subjected to the processing conditions, particularly elevated temperature, during the manufacture of display devices. Examples of polymeric substrates which exhibit good high-temperature dimensional stability during the high temperature techniques (such as sputtering) used to deposit the barrier layer are the heat-stabilised poly(ethylene naphthalate) (PEN) films disclosed in WO-03/22575-A.

In order to ensure the integrity of the barrier layer and to prevent defects or "pin-holes" therein, the surface of the polymeric substrate must exhibit good smoothness. Any pin-holes in the barrier layer provide pathways for the passage of water vapour and oxygen molecules. The surface smoothness of a polymeric substrate is often inferior to conventional glass substrates. In order to improve the surface smoothness of a polymeric substrate, planarising coating layers have been proposed, for instance in WO-03/87247-A.

It is possible to produce electronic display devices comprising barrier-coated polymeric materials which have greater flexibility and improved impact resistance, and are of lighter weight than glass or quartz sheets of equal thickness. However, improvements in barrier properties are desired.

It is an object of this invention to provide a film with improved barrier properties, particularly a film having good surface smoothness, good high-temperature dimensional stability and high optical clarity, which is suitable for use as a substrate, particularly a flexible substrate, in the manufacture of an electronic or opto-electronic device (particularly one comprising a conductive polymer), including an EL device (particularly an OLED), a photovoltaic cell and semiconductor devices (such as organic field effect transistors, thin film transistors and integrated circuits generally).

According to the present invention, there is provided a method of manufacture of a composite film, particularly a composite film suitable for use as a substrate in an electronic or opto-electronic device (particularly wherein the device comprises a conductive polymer), wherein said method comprises the steps of:

(i) forming a polymeric substrate layer;
(ii) stretching the substrate layer in at least one direction;
(iii) heat-setting under dimensional restraint at a tension in the range of about 19 to about 75 kg/m of film width, at a temperature above the glass transition temperature of the polymer of the substrate layer but below the melting temperature thereof;
(iv) heat-stabilising the film at a temperature above the glass transition temperature of the polymer of the substrate layer but below the melting temperature thereof;
(v) applying a planarising coating composition such that the surface of said coated substrate exhibits an Ra value of less than 0.7 nm and/or an Rq value of less than 0.9 nm; and characterised by
(vi) providing an inorganic barrier layer of thickness from 2 to 1000nm by a high-energy vapour deposition process selected from microwave-activated reactive magnetron sputtering, preferably microwave-activated pulsed DC reactive magnetron sputtering.

As used herein, an opto-electronic device preferably refers to an EL device (particularly an OLED) and a photovoltaic device, and particularly an EL device (particularly an OLED). As used herein, the term electronic device excludes opto-electronic devices and preferably refers to semiconductor devices such as organic field effect, transistors, thin film transistors and integrated circuits generally, and particularly organic field effect transistors.

The planarising coating layer is disposed between the polymeric substrate and the inorganic barrier layer, so that the layer order is polymeric substrate/planarising coating layer/inorganic barrier layer.

In a preferred embodiment, the substrate is a polyester film, such as poly(ethylene terephthalate) (PET) or poly(ethylene naphthalate) (PEN), preferably PEN, and preferably a heat-stabilised, heat-set, oriented polyester film.

In a particularly preferred embodiment, the substrate is as described in WO-03/22575-A, and the disclosure therein of such substrates is incorporated herein by reference. Thus, the substrate is preferably a heat-stabilised, heat-set oriented film comprising poly(ethylene naphthalate). Preferably, said substrate has a coefficient of linear thermal expansion (CLTE) within the temperature range from -40 °C to +100 °C of less than $40 \times 10^{-6}/°C$, preferably less than $30 \times 10^{-6}/°C$, more preferably less than $25 \times 10^{-6}/°C$, more preferably less than $20 \times 10^{-6}/°C$. In one embodiment, said substrate has a coefficient of linear thermal expansion (CLTE) within the temperature range from -40 °C to +120 °C of less than $40 \times 10^{-6}/°C$, preferably less than $30 \times 10^{-6}/°C$, more preferably less than $25 \times 10^{-6}/°C$, more preferably less than $20 \times 10^{-6}/°C$.

For a PET substrate, the coefficient of linear thermal expansion (CLTE) within the temperature range from -40 °C to +80 °C is preferably less than $40 \times 10^{-6}/°C$, preferably less than $30 \times 10^{-6}/°C$, more preferably less than $25 \times 10^{-6}/°C$, more preferably less than $20 \times 10^{-6}/°C$.

Preferably, the substrate (particularly a PEN substrate) has a shrinkage at 30 mins at 230°C, measured as defined herein, of less than 1%, preferably less than 0.75%, preferably less than 0.5%, preferably less than 0.25%, and more preferably less than 0.1%. In one embodiment, the substrate (particularly a PEN substrate) has a shrinkage at 30 mins at 150°C, measured as defined herein, of less than 0.5%, preferably less than 0.25%, preferably less than 0.1%, and more preferably 0.05% or less. In one embodiment, the substrate (particularly a PET substrate) has a shrinkage at 30 mins at 120°C, measured as defined herein, of less than 0.5%, preferably less than 0.25%, preferably less than 0.1%, and more preferably 0.05% or less.

Preferably, the substrate has a residual dimensional change $\Delta L_r$ measured at 25°C before and after heating the film from 8°C to 200°C and then cooling to 8°C, of less than 0.75%, preferably less than 0.5 %, preferably less than 0.25%, and more preferably less than 0.1%, of the original dimension.

In a particularly preferred embodiment, the substrate is a heat-stabilised, heat-set oriented film comprising poly(ethylene naphthalate) having the afore-mentioned shrinkage characteristics after 30 min at 230°C, and preferably having the afore-mentioned residual dimensional change $\Delta L_r$ characteristics. The preferred PEN substrates and their preparation are described in more detail below, although it will be appreciated that the general principles are also applicable to other substrates such as PET substrates.

The substrate is self-supporting by which is meant capable of independent existence in the absence of a supporting base. The thickness of the substrate is preferably between about 12 and 300μm, more preferably between about 25 and 250 μm, more preferably between about 50 and 250 μm.

PEN polyester can be synthesised by conventional methods. A typical process involves a direct esterification or ester exchange reaction, followed by polycondensation. Thus, PEN polyester may be obtained by condensing 2,5-, 2,6- or 2,7-naphthalenedicarboxylic acid, preferably 2,6-naphthalenedicarboxylic acid, or a lower alkyl (up to 6 carbon atoms) diester thereof, with ethylene glycol. Typically, polycondensation includes a solid phase polymerisation stage. The solid phase polymerisation may be carried out on a fluidised bed, e.g. fluidised with nitrogen, or on a vacuum fluidised bed, using a rotary vacuum drier. Suitable solid phase polymerisation techniques are disclosed in, for example, EP-A-0419400 the disclosure of which is incorporated herein by reference.

In one embodiment, the PEN is prepared using germanium catalysts which provide a polymeric material having a reduced level of contaminants such as catalyst residues, undesirable inorganic deposits and other by-products of the polymer manufacture. The "cleaner" polymeric composition promotes improved optical clarity and surface smoothness.

The PEN used to prepare the substrate suitably has a PET-equivalent intrinsic viscosity (IV; measured as described herein) of 0.5-1.5, preferably 0.7-1.5, and in particular 0.79-1.0. An IV of less than 0.5 results in a polymeric film lacking desired properties such as mechanical properties whereas an IV of greater than 1.5 is difficult to achieve and would likely lead to processing difficulties of the raw material.

Formation of the substrate may be effected by conventional techniques well-known in the art. Conveniently, formation of the substrate is effected by extrusion, in accordance with the procedure described below. In general terms the process comprises the steps of extruding a layer of molten polymer, quenching the extrudate and orienting the quenched extrudate in at least one direction.

The substrate may be uniaxially-oriented, but is preferably biaxially-oriented. Orientation may be effected by any process known in the art for producing an oriented film, for example a tubular or flat film process. Biaxial orientation is effected by drawing in two mutually perpendicular directions in the plane of the film to achieve a satisfactory combination of mechanical and physical properties.

In a tubular process, simultaneous biaxial orientation may be effected by extruding a thermoplastics polyester tube which is subsequently quenched, reheated and then expanded by internal gas pressure to induce transverse orientation, and withdrawn at a rate which will induce longitudinal orientation.

In the preferred flat film process, the substrate-forming polyester is extruded through a slot die and rapidly quenched upon a chilled casting drum to ensure that the polyester is quenched to the amorphous state. Orientation is then effected by stretching the quenched extrudate in at least one direction at a temperature above the glass transition temperature of the polyester. Sequential orientation may be effected by stretching a flat, quenched extrudate firstly in one direction, usually the longitudinal direction, i.e. the forward direction through the film stretching machine, and then in the transverse direction. Forward stretching of the extrudate is conveniently effected over a set of rotating rolls or between two pairs of nip rolls, transverse stretching then being effected in a stenter apparatus. Alternatively, orientation may be generated in the extruded film by way of simultaneous stretching. Here, the film is stretched in the longitudinal and transverse directions in what is essentially the same stage of the process, in the stenter oven. For both routes of sequential and simultaneous stretching, the extent of stretching is determined partly by the nature of the polyester. However, a PEN film is usually stretched so that the dimension of the oriented film is from 2 to 5.5 times, preferably 2.5 to 5 times its original dimension in each direction of stretching. Typically, stretching of a PEN film is effected at temperatures in the range of 70 to 160°C, typically 70 to 155°C. Greater draw ratios (for example, up to about 8 times) may be used if orientation in only one direction is required. It is desired to obtain a film having balanced properties, which may be achieved for example controlling the stretching conditions in the machine and transverse directions.

The stretched film is dimensionally stabilised by heat-setting under dimensional restraint at a temperature above the glass transition temperature of the polyester but below the melting temperature thereof, to induce crystallisation of the polyester, as described in GB-A-838708. The tension of dimensional restraint is in the range of about 19 to about 75 kg/m, preferably about 45 to about 50 kg/m of film width which, for a film having a width of about 2.6 m is a tension in the range of about 50 to about 190 kg, preferably in the range of 120-130 kg. The actual heat-set temperature and time will vary depending on the composition of the film but should be selected so as not to substantially degrade the tear resistant properties of the film. Within these constraints, a heat-set temperature of about 135° to 250°C is generally desirable, more preferably 235-240°C. The duration of heating will depend on the temperature used but is typically in the range of 5 to 40 secs, preferably 8 to 30 secs.

The film is then further heat-stabilised by heating it under minimal physical restraint at a temperature above the glass transition temperature of the polyester but below the melting point thereof, in order to allow the majority of the inherent shrinkage in the film to occur (relax out) and thereby produce a film with very low residual shrinkage and consequently high dimensional stability. The film shrinkage or relaxation which occurs during the further heat-stabilisation stage is effected either by controlling the line tension experienced by the film at elevated temperature or by controlling the line-speed. The tension experienced by the film is a low tension and typically less than 5 kg/m, preferably less than 3.5 kg/m, more preferably in the range of from 1 to about 2.5 kg/m, and typically in the range of 1.5 to 2 kg/m of film width. For a relaxation process which controls the film speed, the reduction in film speed (and therefore the strain relaxation) is typically in the range 0 to 2.5 %, preferably 0.5 to 2.0%. There is no increase in the transverse dimension of the film during the heat-stabilisation step. The temperature to be used for the heat stabilisation step can vary depending on the desired combination of properties from the final film, with a higher temperature giving better, i.e. lower, residual shrinkage properties. A temperature of 135°C to 250°C is generally desirable, preferably 190 to 250°C, more preferably 200 to 230°C, and more preferably at least 215°C, typically 215 to 230°C. The duration of heating will depend on the temperature used but is typically in the range of 10 to 40 sec, with a duration of 20 to 30 secs being preferred. This heat stabilisation process can be carried out by a variety of methods, including flat and vertical configurations and either "off-line" as a separate process step or "in-line" as a continuation of the film manufacturing process. In one embodiment, heat stabilisation is conducted "off line".

The substrate may comprise one or more discrete layers. The composition of the respective layers may be the same or different. For instance, the substrate may comprise one, two, three, four or five or more layers and typical multi-layer structures may be of the AB, ABA, ABC, ABAB, ABABA or ABCBA type. Preferably, the substrate comprises only one layer. Where the substrate comprises more than one layer, preparation of the substrate is conveniently effected by coextrusion, lamination or casting, in accordance with conventional techniques well-known in the art.

The substrate may conveniently contain any of the additives conventionally employed in the manufacture of polymeric films. Thus, agents such as cross-linking agents, dyes, pigments, voiding agents, lubricants, anti-oxidants, radical scavengers, UV absorbers, thermal stabilisers, flame retardants, anti-blocking agents, surface active agents, slip aids, optical brighteners, gloss improvers, prodegradents, viscosity modifiers and dispersion stabilisers may be incorporated as appropriate. The components of the substrate may be mixed together in a conventional manner.

In a preferred embodiment, the film described herein is optically clear, preferably having a % of scattered visible light (haze) of <3.5 %, preferably <2%, more preferably <1.5 %, more preferably ≤1 %, and particularly less than 0.7%, measured according to the standard ASTM D 1003. In one embodiment, the haze is in the range of 0.6 to 1.0%. Preferably the total light transmission (TLT) in the range of 400-800 nm is at least 75%, preferably at least 80%, and more preferably at least 85%, measured according to the standard ASTM D 1003. In this embodiment, filler is typically present in only small amounts, generally not exceeding 0.5% and preferably less than 0.2% by weight of a given layer.

In an alternative embodiment, the substrate is opaque and highly filled, preferably exhibiting a Transmission Optical Density (TOD) (Sakura Densitometer; type PDA 65; transmission mode) in the range from 0.1 to 2.0, more preferably 0.2 to 1.5, more preferably from 0.25 to 1.25, more preferably from 0.35 to 0.75 and particularly 0.45 to 0.65. The film is conveniently rendered opaque by incorporation into the polymer blend of an effective amount of an opacifying agent. Suitable opacifying agents include an incompatible resin filler, a particulate inorganic filler or a mixture of two or more such fillers. Preferred particulate inorganic fillers include titanium dioxide and silica. Suitable incompatible resins include polyamides and olefin polymers, particularly a homo- or copolymer of a mono-alpha-olefin containing up to 6 carbon atoms in its molecule. The amount of filler present in a given layer is preferably in the range from 1% to 30%, more preferably 3% to 20%, particularly 4% to 15%, and especially 5% to 10% by weight, based on the weight of the layer polymer.

Prior to application of the planarising coating composition to the substrate, it may be desirable to pretreat the substrate to promote adhesion of the coating. Various adhesion promoting techniques known to those skilled in the art can be used, such as flame treating, corona discharge, and/or resin coating.

In a preferred embodiment, the substrate is coated with a primer layer to improve adhesion of the substrate to the planarising coating composition. The primer layer may be any suitable adhesion-promoting polymeric composition known in the art, including polyester and acrylic resins. The primer composition may also be a mixture of a polyester resin with an acrylic resin. Acrylic resins may optionally comprise oxazoline groups and polyalkylene oxide chains. The polymer(s) of the primer composition is/are preferably water-soluble or water-dispersible.

Polyester primer components include those obtained from the following dicarboxylic acids and diols. Suitable di-acids include terephthalic acid, isophthalic acid, phthalic acid, phthalic anhydride, 2,6-naphthalenedicarboxylic acid, 1,4-cyclohexanedicarboxylic acid, adipic acid, sebacic acid, trimellitic acid, pyromellitic acid, a dimer acid, and 5-sodium sulfoisophthalic acid. A copolyester using two or more dicarboxylic acid components is preferred. The polyester may optionally contain a minor amount of an unsaturated di-acid component such as maleic acid or itaconic acid or a small amount of a hydroxycarboxylic acid component such as p-hydroxybenzoic acid. Suitable diols include ethylene glycol, 1,4-butanediol, diethylene glycol, dipropylene glycol, 1,6-hexanediol, 1,4-cyclohexanedimethylol, xylene glycol, dimethylolpropane, poly(ethylene oxide) glycol, and poly(tetramethylene oxide) glycol. The glass transition point of the polyester is preferably 40 to 100°C, further preferably 60 to 80°C. Suitable polyesters include copolyesters of PET or PEN with relatively minor amounts of one or more other dicarboxylic acid comonomers, particularly aromatic di-acids such as isophthalic acid and sodium sulphoisophthalic acid, and optionally relatively minor amounts of one or more glycols other than ethylene glycol, such as diethylene glycol.

In one embodiment, the primer layer comprises an acrylate or methacrylate polymer resin. The acrylic resin may comprise one or more other comonomers. Suitable comonomers include alkyl acrylates, alkyl methacrylates (where the alkyl group is preferably methyl, ethyl, n-propyl, isopropyl, n-butyl, isobutyl, t-butyl, 2-ethylhexyl, cyclohexyl or the like); hydroxy-containing monomers such as 2-hydroxyethyl acrylate, 2-hydroxyethyl methacrylate, 2-hydroxypropyl acrylate, and 2-hydroxypropyl methacrylate; epoxy group-containing monomers such as glycidyl acrylate, glycidyl methacrylate, and allyl glycidyl ether; carboxyl group or its salt-containing monomers, such as acrylic acid, methacrylic acid, itaconic acid, maleic acid, fumaric acid, crotonic acid, styrenesulfonic acid and their salts (sodium salt, potassium salt, ammonium salt, quaternary amine salt or the like); amide group-containing monomers such as acrylamide, methacrylamide, an N-alkylacrylamide, an N-alkylmethacrylamide, an N,N-dialkylacrylamide, an N,N-dialkyl methacrylate (where the alkyl group is preferably selected from those described above), an N-alkoxyacrylamide, an N-alkoxymethacrylamide, an N,N-dialkoxyacrylamide, an N,N-dialkoxymethacrylamide (the alkoxy group is preferably methoxy, ethoxy, butoxy, isobutoxy or the like), acryloylmorpholine, N-methylolacrylamide, N-methylolmethacrylamide, N-phenylacrylamide, and N-phenylmethacrylamide; acid anhydrides such as maleic anhydride and itaconic anhydride; vinyl isocyanate, allyl isocyanate, styrene, $\alpha$-methylstyrene, vinyl methyl ether, vinyl ethyl ether, a vinyltrialkoxysilane, a monoalkyl maleate, a monoalkyl fumarate, a monoalkyl itaconate, acrylonitrile, methacrylonitrile, vinylidene chloride, ethylene, propylene, vinyl chloride, vinyl acetate, and butadiene. In a preferred embodiment, the acrylic resin is copolymerised with one or more monomer(s) containing oxazoline groups and polyalkylene oxide chains.

The oxazoline group-containing monomer includes 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, and 2-isopropenyl-5-methyl-2-oxazoline. One or more comonomers may be used. 2-Isopropenyl-2-oxazoline is preferred.

The polyalkylene oxide chain-containing monomer includes a monomer obtained by adding a polyalkylene oxide to the ester portion of acrylic acid or methacrylic acid. The polyalkylene oxide chain includes polymethylene oxide, polyethylene oxide, polypropylene oxide, and polybutylene oxide. It is preferable that the repeating units of the polyalkylene oxide chain are 3 to 100.

Where the primer composition comprises a mixture of polyester and acrylic components, particularly an acrylic resin comprising oxazoline groups and polyalkylene oxide chains, it is preferable that the content of the polyester is 5 to 95 % by weight, preferably 50 to 90 % by weight, and the content of the acrylic resin is 5 to 90 % by weight, preferably 10 to 50 % by weight.

Other suitable acrylic resins include:

(i) a copolymer of (a) 35 to 40 mole % alkyl acrylate, (b) 35 to 40 % alkyl methacrylate, (c) 10 to 15 mole % of a comonomer containing a free carboxyl group such as itaconic acid, and (d) 15 to 20 mole % of an aromatic sulphonic acid and/or salt thereof such as p-styrene sulphonic acid, an example of which is a copolymer comprising ethyl acrylate/methyl methacrylate/itaconic acid/p-styrene sulphonic acid and/or a salt thereof in a ratio of 37.5/37.5/10/15 mole %, as disclosed in EP-A-0429179 the disclosure of which is incorporated herein by reference; and
(ii) an acrylic and/or methacrylic polymeric resin, an example of which is a polymer comprising about 35 to 60 mole % ethyl acrylate, about 30 to 55 mole % methyl methacrylate and about 2 to 20 mole % methacrylamide, as disclosed in EP-A-0408197 the disclosure of which is incorporated herein by reference.

The primer or adherent layer may also comprise a cross-linking agent which improves adhesion to the substrate and should also be capable of internal cross-linking. Suitable cross-linking agents include optionally alkoxylated condensation products of melamine with formaldehyde. The primer or adherent layer may also comprise a cross-linking catalyst, such as ammonium sulphate, to facilitate the cross-linking of the cross-linking agent. Other suitable cross-linking agents and catalysts are disclosed in EP-A-0429179, the disclosures of which are incorporated herein by reference.

The primer coating may also contain a minor amount of one or more types of filler particles in order to assist in the handling of the film, particularly wherein the planarising coating composition is coated off-line. In one embodiment, the filler may comprise silica, and/or composite inorganic particles of silica with titania. The average particle diameter of the fine particles is preferably ranged from 40 to 120 nm.. The primer coating should not be detrimental to the optical qualities of the substrate as described herein.

The primer layer may optionally contain an aliphatic wax to improve the handling and slip properties of the film surface. The content of the aliphatic wax is preferably at least 0.5 % by weight in order to obtain the improvement, and preferably is 0.5 to 30%, further preferably 1 to 10 % by weight. It is undesirable that the content exceeds 30 % by weight, because the adhesion of the primer layer to the polyester film substrate and the subsequently-applied layer may deteriorate. Suitable aliphatic wax include vegetable waxes such as carnauba wax, candelilla wax, rice wax, Japan tallow, jojoba oil, palm wax, rosin-modified wax, ouricury wax, sugarcane wax, esparto wax, and bark wax; animal waxes such as beeswax, lanolin, spermaceti, insect wax, and shellac wax; mineral waxes such as montan wax, ozokerite, and ceresin wax; petroleum waxes such as paraffin wax, microcrystalline wax; and petrolatum, and synthetic hydrocarbon waxes such as Fischer-Tropsch wax, polyethylene wax, polyethylene oxide wax, polypropylene wax, and polypropylene oxide wax. Carnauba wax, paraffin wax and polyethylene wax are preferred. It is preferable to use the waxes as water dispersions.

The primer coating may also comprise an anti-static agent and/or a wetting agent, as known in the art.

A further suitable primer is disclosed in US-3,443,950, the disclosure of which is incorporated herein by reference.

The coating of the primer layer onto the substrate may be performed in-line or off-line, but is preferably performed "in-line", and preferably between the forward and sideways stretches of a biaxial stretching operation.

The optionally primed substrate is then coated with a planarising composition. As used herein, the term "planarising coating composition" refers to a polymeric coating composition which increases the surface smoothness of a substrate when applied thereto, such that the surface smoothness is improved such that the Ra value, as measured herein, is less than 0.7 nm, preferably less than 0.6 nm, preferably less than 0.5 nm, preferably less than 0.4 nm, preferably less than 0.3 nm, and ideally less than 0.25 nm, and/or such that the Rq value, as measured herein, is less than 0.9 nm, preferably less than 0.8 nm, preferably less than 0.75 nm, preferably less than 0.65 nm, preferably less than 0.6 nm, preferably less than 0.50 nm, preferably 0.45nm or lower, preferably less than 0.35 nm, and ideally less than 0.3 nm.

In a preferred embodiment, the planarising coating composition is a polysiloxane, preferably a polysiloxane as described in WO-03/87247-A, and comprises a polysiloxane derived from a composition comprising:

(a) about from 5 to 50 weight percent solids, the solids comprising about from 10 to 70 weight percent silica and about from 90 to 30 weight percent of a partially polymerized organic silanol of the general formula $RSi(OH)_3$, wherein R is selected from methyl and up to about 40% of a group selected from the group consisting of vinyl, phenyl, gamma-glycidoxypropyl, and gamma-methacryloxypropyl, and
(b) about from 95 to 50 weight percent solvent, the solvent comprising about from 10 to 90 weight percent water and about from 90 to 10 weight percent lower aliphatic alcohol,

wherein the coating composition has a pH of from about 3.0 to about 8.0, preferably from about 3.0 to about 6.5.

The preferred polysiloxane planarising coating compositions provide a surface which results in particularly effective barrier properties when a barrier layer, particularly a silicon dioxide barrier layer, is applied thereon according to the preferred deposition techniques described hereinbelow.

Preferably, the pH of the coating composition is less than 6.2, preferably about 6.0 or less. Preferably, the pH of the coating composition is at least 3.5, preferably at least 4.0. In one embodiment, the pH of the coating composition is in the range of from about 4.0 to about 5.0, preferably from about 4.1 to about 4.8, preferably from about 4.3 to about 4.5. The pH of the coating solution can be adjusted according to techniques well known to those skilled in the art, including the addition of an acidic or basic solution. For example, suitable acids for the adjustment of the pH include hydrochloric and acetic acids, and suitable bases include sodium hydroxide.

The silica component of the coating compositions may be obtained, for example, by the hydrolysis of tetraethyl orthosilicate to form polysilicic acid. The hydrolysis can be carried out using conventional procedures, for example, by the addition of an aliphatic alcohol and an acid. Alternatively, the silica used in the instant coating compositions can be colloidal silica. The colloidal silica should generally have a particle size of about from 5-25 nm, and preferably about from 7-15 nm. Typical colloidal silicas which can be used in the instant invention include those commercially available as "Ludox SM", "Ludox HS-30" and "Ludox LS" dispersions (Grace Davison).

The organic silanol component has the general formula $RSi(OH)_3$. At least about 60% of the R groups, and preferably about from 80% to 100% of these groups, are methyl. Up to about 40% of the R groups can be higher alkyl or aryl selected from vinyl, phenyl, gamma-glycidoxypropyl, and gamma-methacryloxypropyl.

The combined solids of the coating composition, comprising the silica and the partially polymerized organic silanol, make up about from 5 to 50 weight percent of the total coating composition. Of these solids, the silica should comprise about from 10 to 70 weight percent, and preferably about from 20 to 60 weight percent, the complementary remainder comprising the organic siloxanol. Weight percents of the organic siloxanol herein are calculated as $RSiO_{1.5}$.

The solvent component of the coating compositions generally comprises a mixture of water and one or more lower aliphatic alcohols. The water generally comprises about from 10 to 90 weight percent of the solvent, while the lower aliphatic alcohol complementarily comprises about from 90 to 10 weight percent. The aliphatic alcohols generally are those having from 1 to 4 carbon atoms, such as methanol, ethanol, n-propanol, iso-propanol, n-butanol, sec-butanol and tertiary butanol.

In addition to the basic solvent components of water and alcohol, the solvent portion of the compositions can further comprise up to about 10 weight percent of a compatible polar solvent such as acetone, ethylene glycol monoethylether, ethylene glycol monobutylether and diethylene glycol monoethylether.

Still further components which can be present in the coating compositions include curing catalysts. These are preferably present in a concentration of about from 0.01% to 0.1% based on the total weight of the composition, and especially about from 0.01 to 0.3 weight percent. Curing catalysts which may be used in the coating compositions can vary widely. Representative catalysts include the alkali metal salts of carboxylic acids such as sodium acetate, potassium acetate, sodium formate, and potassium formate. Other representative curing catalysts which can be used include the quaternary ammonium carboxylates, such as benzyltrimethylammonium acetate.

Other suitable coating compositions are disclosed in US-5069942 and US-5415942, the disclosures of which are incorporated herein by reference. The compositions disclosed therein have a reduced alkali metal cation content (alkali metals had been used to stabilise silica hydrosols) and exhibit, inter alia, improved adhesion to a polymeric substrate.

The compositions can be prepared by wide variety of techniques, depending on the particular starting materials used. For example, organotrialkoxysilane can be hydrolyzed in the presence of prehydrolyzed polysilicic acid. Alternatively, organotrialkoxysilane can be prehydrolyzed and then added to a solution of polysilicic acid, often resulting in particularly rapid cure times. Still another alternative in the preparation of these compositions is the cohydrolysis of organotrialkoxysilane and tetraethyl orthosilicate together.

If a colloidal silica is used as the silica source in the coating compositions, the organic silanol can be combined with the silica either through the prehydrolysis of the organotrialkoxysilane or by hydrolyzing the organotrialkoxysilane in the presence of acidified colloidal silica dispersion. Still other methods of preparing and combining the components required for the compositions will be evident to those skilled in the handling of the individual components.

The coating compositions can be applied using conventional coating techniques, including continuous as well as dip coating procedures. The coatings are generally applied at a dry thickness of from about 1 to about 20 microns, preferably from about 1.5 to 10 microns, preferably from about 2 to 10 microns, particularly from about 3 to about 10 microns. The coating composition can be applied either "off-line" as a process step distinct from the film manufacture, or "in-line" as a continuation of the film manufacturing process. In order to improve the surface smoothness of the coated film, it is desirable to avoid contamination from dust-particles and the like, and so the coating is preferably conducted off-line in a dust-free environment.

The coating compositions, after application to the substrate, can be cured at a temperature of from about 20 to about 200°C, preferably from about 20 to about 150°C. While ambient temperatures of 20°C require cure times of several days, elevated temperatures of 150°C will cure the coatings in several seconds.

Once the substrate layer has been planarised, the inorganic barrier layer is applied. In one aspect, the invention resides in the combination of the planarised substrate and an inorganic barrier layer applied in the manner described below, in order to achieve the improvements in barrier properties described herein. The barrier layer is preferably from about 2 to about 750nm, preferably about 2 to about 500nm, preferably about 10 to about 400 nm in thickness, and in one embodiment about 2 to about 300nm and preferably 10 to about 200nm in thickness. Suitable materials for formation of the barrier layer are inorganic materials which exhibit low moisture permeability and are stable against moisture. Examples include oxides such as $SiO_2$, $SiO$, $GeO$, $Al_2O_3$, $ZrO_2$ and the like, nitrides such as $TiN$, $Si_3N_4$ and the like, and metals such as Al, Ag, Au, Pt, Ni and the like. In a preferred embodiment, the barrier layer comprises silicon dioxide, $ZrO_2$ or $Si_3N_4$, and preferably silicon dioxide. The barrier layer may comprise two or more discrete layers of inorganic material, the same or different, and preferably the same, which are applied in successive steps. Preferably the barrier layer comprises one layer of inorganic material.

It has been found that improved barrier properties are provided by applying the barrier material using vapour deposition techniques in which the energy input into the system is higher than in conventional techniques. Suitable processes are microwave activated reactive magnetron sputtering techniques. It is believed that the preferred higher energy techniques modify the morphology of the inorganic barrier material, which may lead to increases in its density by providing a more-closely-packed layer. The inventors believe that the techniques used may avoid columnar patterns of growth of the barrier material deposited on the substrate. Columnar growth patterns may allow vapour diffusion through the nano-scale spacings of the coated barrier material, thereby reducing the barrier properties.

Sputtering is a well-known technique for the deposition of thin film coatings, and has a number of variations. In its basic form, a solid target, containing one or more of the elements in the chemical makeup of the desired thin film, is bombarded with energetic ions of a sputtering gas (usually an inert gas such as argon). These energetic ions are capable of physically removing atoms from at least part of the target surface. The target is normally contained in a chamber, firstly evacuated to an initial pressure for the removal of air and water vapour and subsequently backfilled with inert gas to a working pressure. The atoms removed (sputtered) from the target are free to travel distances of at least several centimetres in the reduced pressure of the chamber without losing too much energy through collisions with other gas atoms/molecules. At least some of the sputtered atoms arrive at a substrate, where at least some of them adhere and form a thin film coating. The process is continued until the desired thickness of the thin film coating is obtained. Multiple targets and multiple power supplies may be used to increase deposition rates or to ensure uniformity.

In the process of magnetron sputtering, a magnetic field is created behind the target in such a way as to increase the level of ionisation of the sputtering gas. This leads to a large increase in the removal rate of atoms from the target and hence decreases the time necessary to obtain a given coating thickness. There are a number of other advantages, including the increase in stability of the process for a wide range of working pressures. Multiple magnetrons may be used to increase deposition rates or to ensure uniformity.

In the process of reactive sputtering, a reactive gas, such as oxygen and/or nitrogen, is introduced into the chamber, in addition to, or instead of the sputtering gas. The reactive gas combines with the sputtered atoms to form a compound thin film such as an oxide or nitride or oxynitride layer on the substrate. In its most common embodiment, a solid elemental target is used with a sputtering gas and a reactive gas (for example a solid aluminium target may be sputtered by argon in the presence of oxygen to form an aluminium oxide, in which the aluminium to oxygen ratio may or may not have the usual stoichiometric ratio).

In the process of DC (direct current) sputtering, a direct current power supply is used. Alternative power supplies are alternating current (AC) at frequencies of several kilohertz, and radio frequency (RF) power supplies. High power DC supplies are substantially cheaper than the alternatives and DC sputtering is particularly suitable for the deposition of metallic thin films.

In the process of pulsed DC sputtering, the DC power supply is pulsed (unipolar or bipolar). This method avoids any problems with reactive magnetron sputtering caused by the formation of oxide on parts of the target that were not being sputtered at high rate. These deposits act as a dielectric capacitor, being charged up by the DC power supply and sputtering gas ions. Eventually dielectric breakdown occurs, leading to very large localised currents being drawn from the power supply and also to the ejection of droplets or particulates from the target surface onto the substrate. This is detrimental to the power supply and to the quality of the coating. Pulsing the power supply makes it possible to reduce this effect by dissipating the charge build-up on the target oxide, and has the additional benefit of increasing the average energy of the sputtering gas ions, and sputtered atoms.

In the process of microwave-activated (or microwave-assisted) sputtering, a microwave plasma source is used to activate the reactive gas in the sputtering chamber during the deposition of the barrier layer, and/or to effect a plasma pre-treatment of the substrate prior to deposition of the sputtered atoms. Microwave activation is especially advantageous in reactive sputtering, since the plasma is more reactive than the gas would otherwise be and forms the desired compound thin film more readily. Multiple microwave sources may be employed.

Thus, the process described herein involves the creation of a plasma environment in the sputtering chamber. As used herein, the term "plasma" refers to a high-temperature ionized gaseous atmosphere (which may also comprise some non-ionized molecules or atoms) in which there is no resultant charge, the number of positive and negative ions being equal.

A single plasma source or multiple plasma sources may be used, and where multiple sources are used, they may be used either sequentially or simultaneously. The multiple sources may be the same or different. In a preferred embodiment, plasma is generated from multiple sources, for instance, microwave and magnetron plasma sources, typically separated spatially in the apparatus.

As used herein, a "higher energy vapour deposition technique" refers to processes such as reactive magnetron sputtering and pulsed DC reactive magnetron sputtering, in which the energy input into the system is higher than in a conventional sputtering technique. Such processes when conducted without plasma-enhancement (as defined hereinbelow) are of particularly utility with the preferred planarising and barrier layers described herein.

The preferred processes of the invention is microwave activated reactive magnetron sputtering, which is a plasma-enhanced process. As used herein, a process which is "plasma-enhanced" refers to a process wherein:

(i) there is an additional plasma source (relative to a conventional vapour deposition environment, such as a conventional sputtering or magnetron sputtering process) during the deposition of the barrier layer, and includes processes in which two or more plasma sources are used (for instance, microwave-activated reactive magnetron sputtering) during the deposition of the barrier layer; and/or wherein

(ii) a plasma source (for instance a microwave source) is utilised to effect a plasma pre-treatment of the substrate prior to deposition of the barrier layer.

Preferably, the process of the present invention comprises the step of effecting a plasma pre-treatment of the planarised substrate prior to the deposition of the inorganic barrier coating, and preferably further comprises the aforementioned additional plasma source during the deposition of the barrier layer. In one embodiment, plasma pre-treatment is effected in the sputtering gas (preferably argon or argon and oxygen, preferably argon and oxygen) for a period of between about 2 and 8 minutes, and preferably about 5 minutes. Preferably, the plasma pre-treatment is microwave-activated, i.e. is effected using a microwave plasma source, typically without another plasma source.

The preferred sputtering method in the present invention is microwave-activated pulsed DC reactive magnetron sputtering.

In the sputtering process, the initial pressure is preferably no greater than $10^{-6}$ torr. The working pressure is preferably in the range of 2 to 5 millitorr. The sputtering gas is preferably argon. The reactive gas is preferably oxygen. Any target conventional in the sputtering art may be used, including silicon or other lightly doped silicon target, typically a boron-doped silicon target. Preferably the DC power is in the range of about 2 to about 6 kW (for rectangular targets of approximate size 38 x 13 cm). Preferably, the microwave power is in the range of about 1 to about 3 kW.

The composite film comprising the barrier layer preferably exhibits a water vapour transmission rate (WVTR) of less than $10^{-2}$g/m$^2$/day, more preferably less than $10^{-3}$g/m$^2$/day, more preferably less than $10^{-4}$g/m$^2$/day, more preferably less than $10^{-5}$g/m$^2$/day, most preferably less than $10^{-6}$g/m$^2$/day, and/or an oxygen transmission rate (OTR) of less than $10^{-3}$mL/m$^2$/day, more preferably less than $10^{-4}$mL/m$^2$/day, most preferably less than $10^{-5}$ mL/m$^2$/day. The parameters of the sputtering process may be controlled to achieve the desired WVTR and/or OTR.

The composite film comprising polymeric substrate, planarising coating layer and inorganic barrier layer preferably exhibits exceptionally low shrinkage. In a preferred embodiment, the shrinkage of the composite film is no more than 0.01%, preferably no more than 0.005%, preferably no more than 0.0025 %, after 30 minutes at 150°C, measured as defined herein.

In one embodiment, the composite film comprises a substrate layer and on both surfaces thereof a planarising coating layer, as described herein. A symmetrical film of this type is particularly useful in providing a dimensionally stable film in which film curl during subsequent processing is minimised or avoided. In this embodiment, the barrier layer may be provided on one or both surfaces of the coated substrate, and preferably on both surfaces.

Once the barrier layer has been deposited, subsequent layers, including the electrode and electroluminescent material (e.g. the conductive polymer), may be applied in accordance with conventional manufacturing techniques known in the art. The electrode may be any suitable electrode known in the art, for instance an electrode selected from those mentioned herein. In one embodiment, the electrode is a conductive metal oxide, preferably indium tin oxide.

The method of the present invention therefore provides a composite film comprising a substrate layer as described herein and on a surface thereof a planarising coating layer as described herein and on a surface of the coating layer a barrier layer as described herein, and optionally further comprising an electrode layer on at least part of the surface of the barrier layer, and optionally further comprising a layer of electroluminescent material (e.g. the conductive polymer). In one embodiment, the composite film comprises said substrate layer, and on both surfaces thereof said planarising coating layer, and on both surfaces of said coated substrate a barrier layer.

According to a further aspect of the present invention, there is provided a method for the manufacture of an electronic or opto-electronic device (particularly a device containing a conductive polymer), said method comprising the steps of:

(i) forming a polymeric substrate layer;
(ii) stretching the substrate layer in at least one direction;
(iii) heat-setting under dimensional restraint at a tension in the range of about 19 to about 75 kg/m of film width, at a temperature above the glass transition temperature of the polymer of the substrate layer but below the melting temperature thereof;
(iv) heat-stabilising the film at a temperature above the glass transition temperature of the polymer of the substrate layer but below the melting temperature thereof;
(v) applying a planarising coating composition preferably such that the Ra value and/or Rq value satisfy the thresholds described hereinabove;
(vi) applying an inorganic barrier layer of thickness from 2 to 1000nm by microwave-activated reactive magnetron sputtering, preferably microwave-activated pulsed DC reactive magnetron sputtering, whith is preferably plasma-enhanced ; and
(vii) providing the composite film comprising said polymeric substrate layer, said planarising coating layer and said inorganic barrier layer as a substrate in said electronic or opto-electronic device.

The methods of manufacture of the composite film and electronic or opto-electronic device described herein may further comprise providing an electrode layer comprising a conductive material, and this is typically performed by applying a conductive material onto at least part of the barrier layer. A further step in the manufacturing methods described herein is providing a layer of electroluminescent material (e.g. a conductive polymer).

In one embodiment of the invention, the term electroluminescent display device, particularly an organic light emitting display (OLED) device, refers to a display device comprising a layer of light-emitting electroluminescent material (particularly a conductive polymeric material) disposed between two layers each of which comprises an electrode, wherein the resultant composite structure is disposed between two substrate (or support or cover) layers.

In one embodiment of the invention, the term photovoltaic cell refers to a device comprising a layer of conductive polymeric material disposed between two layers each of which comprises an electrode, wherein the resultant composite structure is disposed between two substrate (or support or cover) layers.

In one embodiment of the invention, the term transistor refers to a device comprising at least one layer of conductive polymer, a gate electrode, a source electrode and a drain electrode, and one or more substrate layers.

The following test methods may be used to determine certain properties of the polymeric film:

(i) The clarity of the film may be evaluated by measuring total luminance transmission (TLT) and haze (% of scattered transmitted visible light) through the total thickness of the film using a Gardner XL 211 hazemeter in accordance with ASTM D-1003-61.
(ii) Transmission Optical Density (TOD) of the film may be measured using a Macbeth Densitometer TR 927 (Dent & Woods Ltd, Basingstoke, UK) in transmission mode.
(iii) Dimensional stability may be assessed in terms of either (a) the coefficient of linear thermal expansion (CLTE) or (b) a temperature cycling method wherein the residual change in length along a given axis is measured after heating the film to a given temperature and subsequently cooling the film.
Both methods of measurements were conducted using a Thermomechanical Analyser PE-TMA-7 (Perkin Elmer) calibrated and checked in accordance with known procedures for temperature, displacement, force, eigendeformation, baseline and furnace temperature alignment. The films were examined using extension analysis clamps. The baseline required for the extension clamps was obtained using a very low coefficient of expansion specimen (quartz) and the CLTE precision and accuracy (dependent on post-scan baseline subtraction) was assessed using a standard material, e.g. pure aluminium foil, for which the CLTE value is well known. The specimens, selected from known axes of orientation within the original film samples, were mounted in the system using a clamp separation of approx. 12mm and subjected to an applied force of 75mN over a 5mm width. The applied force was adjusted for changes in film thickness, i.e. to ensure consistent tension, and the film was not curved along the axis of analysis. Specimen lengths were normalised to the length measured at a temperature of 23°C.

In the CLTE test method (a), specimens were cooled to 8°C, stabilised, then heated at 5°C/min from 8°C to +240°C. The CLTE values (a) were derived from the formula:

$$\alpha = \Delta L \, / \, (L \times (T_2 - T_1))$$

where AL is the measured change in length of the specimen over the temperature range ($T_2 - T_1$), and L is the original specimen length at 23°C. CLTE values are considered reliable up to the temperature of the Tg (120°C for PEN). The data can be plotted as a function of the % change in specimen length with temperature, normalised to 23°C.

In the temperature cycling test method (b), a procedure similar to that of method (a) was used wherein the temperature was cycled between 8°C and several elevated temperatures. Thus, film samples were heated from 8°C to 140°C, 160°C, 180°C or 200°C and then cooled to 8°C. The length along each of the transverse and machine directions was measured at 25°C before and after this heat treatment and the change in length $\Delta L_r$ calculated as percentage of the original length.

(iv) Intrinsic Viscosity (IV)

The IV was measured by melt viscometry, using the following procedure. The rate of flow pre-dried extrudate through a calibrated die at known temperature and pressure is measured by a transducer which is linked to a computer. The computer programme calculates melt viscosity values ($\log_{10}$ viscosity) and equivalent IVs from a regression equation determined experimentally. A plot of the IV against time in minutes is made by the computer and the degradation rate is calculated. An extrapolation of the graph to zero time gives the initial IV and equivalent melt viscosity. The die orifice diameter is 0.020 inches, with a melt temperature of 284°C for IV up to 0.80, and 295°C for IV>0.80.

(v) Shrinkage

Shrinkage at a given temperature is measured by placing the sample in a heated oven for a given period of time. The % shrinkage is calculated as the % change of dimension of the film in a given direction before and after heating.

(vi) Surface Smoothness

Surface smoothness was measured using conventional non-contacting, white-light, phase-shifting interferometry techniques, which are well-known in the art. The instrument used was a Wyko NT3300 surface profiler using a light source of wavelength 604nm. With reference to the WYKO Surface Profiler Technical Reference Manual (Veeco Process Metrology, Arizona, US; June 1998; the disclosure of which is incorporated herein by reference), the characterising data obtainable using the technique include:

**Averaging Parameter - Roughness Average (Ra)** : the arithmetic average of the absolute values of the measured height deviations within the evaluation area and measured from the mean surface.

**Averaging Parameter - Root Mean Square Roughness (Rq)** : the root mean square average of the measured height deviations within the evaluation area and measured from the mean surface.

**Extreme Value Parameter - Maximum Profile Peak Height (Rp)** : the height of the highest peak in the evaluation area, as measured from the mean surface.

**Averaged Extreme Value Parameter - Average Maximum Profile Peak Height (Rpm)** : the arithmetic average value of the ten highest peaks in the evaluation area.

**Extreme Peak Height Distribution** : a number distribution of the values of Rp of height greater than 200nm.

**Surface Area Index** : a measure of the relative flatness of a surface.

The roughness parameters and peak heights are measured relative to the average level of the sample surface area, or "mean surface", in accordance with conventional techniques. (A polymeric film surface may not be perfectly flat, and often has gentle undulations across its surface. The mean surface is a plane that runs centrally through undulations and surface height departures, dividing the profile such that there are equal volumes above and below the mean surface.)

The surface profile analysis is conducted by scanning discrete regions of the film surface within the "field of view" of the surface profiler instrument, which is the area scanned in a single measurement. A film sample may be analysed using a discrete field of view, or by scanning successive fields of view to form an array.

The analyses conducted herein utilised the full resolution of the Wyko NT3300 surface profiler, in which each field of view comprises 480 x 736 pixels.

For the measurement of Ra and Rq, the resolution was enhanced using an objective lens having a 50-times magnification. The resultant field of view has dimensions of 90 $\mu$m x 120 $\mu$m, with a pixel size of 0.163 $\mu$m.

For the measurement of Rp and Rpm, the field of view is conveniently increased using an objective lens having a 10-times magnification in combination with a "0.5-times field of view of multiplier" to give a total magnification of 5-times. The resultant field of view has dimensions of 0.9 mm x 1.2 mm, with a pixel size of 1.63 $\mu$m. Preferably Rp is less than 100nm, more preferably less than 60nm, more preferably less than 50nm, more preferably less than 40nm, more preferably less than 30nm, and more preferably less than 20nm.

For the measurement of Ra and Rq herein, the results of five successive scans over the same portion of the surface area are combined to give an average value. The data presented below in respect of Rp are an average value from 100 measurements.

The measurements were conducted using a modulation threshold (signal : noise ratio) of 10%, i.e. data points below the threshold are identified as bad data.

The surface topography can also be analysed for the presence of extreme peaks having a height of greater than 200nm. In this analysis, a series of measurements of Rp are taken with a pixel size of 1.63 $\mu$m over a total area of 5cm$^2$. The results may be presented in the form of a histogram in which the data-points are assigned to pre-determined ranges of peak heights, for instance wherein the histogram has equally-spaced channels along the x-axis of channel width 25nm. The histogram may be presented in the form of a graph of peak count (y axis) versus peak height (x axis). The number of surface peaks in the range 300 to 600 nm per 5cm$^2$ area, as determined from Rp values, may be calculated, and designated as N(300-600). The use of a planarising coating according to the present invention preferably results in a reduction of N(300-600), such that the reduction F, which is the ratio of N(300-600) before and after application of the planarising coating, is at least 5, preferably at least 15, and more preferably at least 30. Preferably, the N(300-600) value of the planarised film (after coating) is less than 50, preferably less than 35, preferably less than 20, preferably less than 10, and preferably less than 5 peaks per 5cm$^2$ area.

The Surface Area Index is calculated from the "3-dimensional surface area" and the "lateral surface area" as follows. The "3-dimensional (3-D) surface area" of a sample area is the total exposed 3-D surface area including peaks and valleys. The "lateral surface area" is the surface area measured in the lateral direction. To calculate the 3-D surface area, four pixels with surface height are used to generate a pixel located in the centre with X, Y and Z dimensions. The four resultant triangular areas are then used to generate approximate cubic volume. This four-pixel window moves through the entire data-set. The lateral surface area is calculated by multiplying the number of pixels in the field of view by the XY size of each pixel. The surface area index is calculated by dividing the 3-D surface area by the lateral area, and is a measure of the relative flatness of a surface. An index which is very close to unity describes a very flat surface where the lateral (XY) area is very near the total 3-D area (XYZ).

A Peak-to-Valley value, referred to herein as "PV$_{95}$", may be obtained from the frequency distribution of positive and negative surface heights as a function of surface height referenced to the mean surface plane. The value PV$_{95}$ is the peak-to-valley height difference which envelops 95% of the peak-to-valley surface height data in the distribution curve by omitting the highest and lowest 2.5% of datapoints. The PV$_{95}$ parameter provides a statistically significant measure of the overall peak-to-valley spread of surface heights.

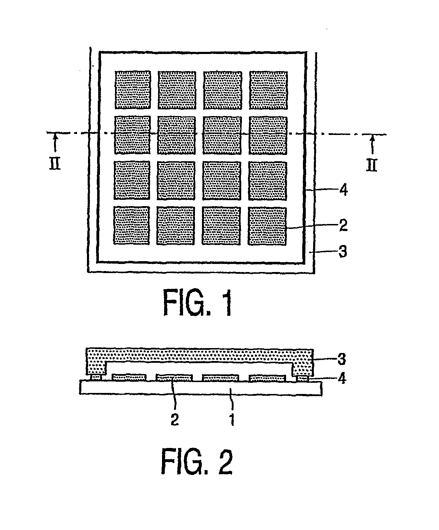

(vii) The permeability of the composite film, and transmission rates for water vapour (in g/m$^2$/day) and/or oxygen (in mL/m$^2$/day) are measured using the calcium degradation test as described in WO-02/079757-A (and also further discussed by G. Nisato, M Kuilder, P. Bouten, L Moro, O. Philips and N. Rutherford in Society For Information Display, Digest of Technical Papers, 2003, 550-553). Figures 1 and 2 show the test cell configuration. Figure 2 is a cross-section along line II-II of Figure 1.

The test substrate is cut into a square of approximately 13x13cm square and heated at 120°C for one hour to remove residual moisture. A thin layer (2) of calcium (100nm) is deposited on the test substrate (1) in an oxygen and water free environment in a pattern of four 20x15mm areas in the centre of the substrate. A glass sheet or lid (3) is interconnected to the substrate along its edge via a substantially hermetic seal (4) to form a closed box. The seal may be for instance glue or a solder metal. The calcium layer is initially a highly reflective metallic mirror. The structure is then placed in a humidity chamber at 60°C and 90% relative humidity to accelerate ageing conditions. During the test, water or oxygen permeating into the box reacts with the calcium to form calcium oxide or calcium hydroxide. The initial layer of calcium metal degrades to an increasingly transparent layer of calcium salt. The transparency or transmission of the layer is an indicator for the amount of water or oxygen having diffused into the box. Pictures of the test cells are taken at regular intervals to follow the evolution of the samples. Automated image analysis of the photos yields the distribution of optical transmission of the calcium layer. A densitometer (e.g. X-rite Model 360) was used to measure the optical density. Optical modelling of the transmission of calcium-calcium salt stacks enables determination of the distribution of the calcium oxide thickness in the cell. The latter can then be related to the amount of absorbed water as a function of time, yielding the effective permeation rate of the encapsulant. The test data may be reported as a graph of optical transmission expressed as a percentage of the original (y axis) against time (x axis). Conveniently, the barrier property can be expressed in terms of the time taken for the optical transmission to drop to 50% of its original value. Preferably, the films of the present invention exhibit a lifetime (in hours) of at least 100, preferably at least 250, preferably at least 500, and more preferably at least 1000, for the optical transmission to fall to 50% of the original value (i.e. at t = 0 hours), particularly in combination with a water vapour transmission rate (WVTR) of less than $10^{-3}$g/m$^2$/day.

(viii) The density of the inorganic layer on different substrates may be calculated from refractive index measurements, following the method of Pulker, H.K. and Schlichtherle, S., ("Density related properties of metal oxide films", Proc SPIE 5250, Advances in Optical Thin Films, p1-11 (2004)), where it was shown that, for a large range of differently prepared $SiO_2$ samples, the density (p) and the measured refractive index (n) are related by:

$$\rho = \frac{n^2 - 1}{\dfrac{\alpha}{M}(4\pi + bn^2 - b)}$$

where $\alpha/M=0.0364$ cm$^3$/g and b=1.3 for silica-based materials.

The refractive index was obtained from photometric measurements as follows. A UV-Vis-IR spectrophotometer (Hitachi U-3501) was used to collect transmittance data on the composite film sample in the wavelength range 350 nm to 850 nm. A spectroscopic ellipsometer (Jobin Yvon UV) was used to measure the ellipsometric parameters, $\Psi$ (Psi) and $\Delta$ (Delta), over the wavelength range 350 nm to 850 nm at incident angles of 55° and 70°. Measurements of transmittance, Psi and Delta are made on the polymeric substrate, the planarised polymeric substrate and the composite film comprising planarised substrate and inorganic barrier layer. From these data, the refractive index (n) of the individual layers is determined by standard methods of least-squares fitting of a theoretical model to the combined transmittance and ellipsometric data. For example, for transparent films such as silica, the refractive index (n) of the layers can be fitted by a standard Cauchy model, whereby the wavelength dependence of n is represented by n($\lambda$), where $\lambda$ is wavelength, in the form:

$$n(\lambda) = a + 10^6 \frac{b}{\lambda^2} + 10^{12} \frac{c}{\lambda^4}, \quad [\lambda] = [nm]$$

where a, b, c are adjustable parameters. Using initial trial values of a, b and c, the transmittance, Psi and Delta can be calculated from n($\lambda$) using well-known formulae (see for example, H.A. MacLeod, "Thin Film Optical Filters", Third Ed., 2001, Bristol and Philadelphia: Institute of Physics Publishing). The parameters a, b and c can subsequently be optimized to obtain the best fit of the calculated data to the combined ellipsometric and transmission experimental data using a Levenberg-Marquardt least-squares routine (see for example, H.A. MacLeod, as above). In one embodiment, the inorganic barrier layer has a density of at least 2.4 g/cm$^3$.

The invention is further illustrated by the following examples. It will be appreciated that the examples are for illustrative purposes only and are not intended to limit the invention as described above. Modification of detail may be made without departing from the scope of the invention.

## EXAMPLES

### Base Film 1 *(Preparation of uncoated substrate)*

Dimethyl naphthalate was reacted with ethylene glycol in the presence of 210 ppm manganese acetate tetrahydrate catalyst to give bis-(2-hydroxyethyl) naphthalate and low oligomers thereof, in a standard ester interchange reaction. At the end of the ester interchange reaction 0.025wt % of phosphoric acid stabiliser was added, followed by 0.036 wt % of antimony trioxide polycondensation catalyst. A standard batch polycondensation reaction was performed.

The polymer composition was extruded and cast onto a hot rotating polished drum. The film was then fed to a forward draw unit where it was stretched over a series of temperature-controlled rollers in the direction of extrusion to approximately 3.1 times its original dimensions. The draw temperature was approximately 145°C. The film was then passed into a stenter oven at a temperature of 145°C where the film was stretched in the sideways directions to approximately 3.5 times its original dimensions. The biaxially stretched film was then heat-set at temperatures up to about 240°C by conventional means before being cooled and wound onto reels. The total film thickness was 125 μm. The heat-set biaxially stretched film was then unwound and passed through a series of four flotation ovens and allowed to relax by applying the minimum line tension compatible with controlling the transport of the web. The heat-stabilised film was then wound up. Each of the four ovens had three controlled temperature zones in the transverse direction (left, centre and right):

|  | Left | Centre | Right |
| --- | --- | --- | --- |
| Oven 1 | 200 | 213 | 200 |
| Oven 2 | 200 | 213 | 200 |
| Oven 3 | 200 | 213 | 200 |
| Oven 4 | 195 | 213 | 195 |

The line speed of the film during the heat-stabilisation step was 15m/min. The tensions used for the film (1360mm original roll width) were 24-25N.

## Base Film 2 *(Preparation of primed substrate)*

The procedure for Base Film 1 was followed except that an aqueous primer coating composition was coated between the forward and sideways stretching steps onto the substrate to give a coat thickness of 50nm. The primer coating had the following solids content:

(i) 67% of a copolyester emulsion (wherein the acidic components of the copolyester comprise 65 mol% of 2,6-naphthalenedicarboxylic acid, 30 mol% of isophthalic acid and 5 mol% of 5-sodium sulfoisophthalic acid, and the glycol components comprise 90 mol% of ethylene glycol and 10 mol% of diethylene glycol; Tg = 80°C; average molecular weight = 13,000; produced in accordance with a method described in Example 1 of JP-A-116487/1994);
(ii) 20% of an aqueous dispersion of an acrylic resin (comprising 30 mol% of methyl methacrylate, 30 mol% of 2-isopropenyl-2-oxazoline, 10 mol% of polyethylene oxide (n =10) methacrylate and 30 mol% of acrylamide; Tg = 50°C; produced in accordance with a method described in Production Examples 1 to 3 of JP-A-37167/1988).
(iii) 3% inert particles (silica and $SiO_2$-$TiO_2$, average particle diameter in the range of 40 to 120nm)
(iv) 5% carnauba wax
(v) 5% polyoxyethylene (n=7) lauryl ether

## Base Film 3 *(Preparation of planarised and primed substrate)*

The procedure for Base Film 2 was followed and the resulting film then coated off-line with a second (planarising) coating composition obtained as follows:

(i) 517 $cm^3$ of methyltrimethoxysilane (obtained from OSi Specialities) was added to 1034 $cm^3$ demineralised water at room temperature and stirred for 24 hours.
(ii) 54 $cm^3$ of 3-glycidoxypropyl trimethoxysilane (obtained from Aldrich Chemical Company) was added to 108 $cm^3$ of demineralised water at room temperature and stirred for 24 hours.
(iii) 53 $cm^3$ of 10 % aqueous acetic acid (Aldrich Chemical Company) was added to 700$cm^3$ of Ludox LS colloidal silica (12 nm). To this was added 162 $cm^3$ of the hydrolysed 3-glycidoxypropyl trimethoxysilane/water mixture and 1551$cm^3$ of the hydrolysed methyltrimethoxysilane/water mixture. This mixture was stirred for 12 hours before coating. The final pH of the composition was 6.05. The coating was cured at 130°C for 1 minute. The thickness of the planarising coating was 2.8 μm ± 0.2 μm.

The surface roughness parameters of Base Film 3 are shown in Table 1.

**Table 1. Surface Roughness**

|  | Base Film 3 |
| --- | --- |
| **Ra (nm)** | 0.47 |
| **Rq (nm)** | 0.62 |

(continued)

|  | Base Film 3 |
|---|---|
| Peak : Valley value $PV_{95}$ (nm) | 2.28 |
| Surface Area Index | 1.000003 |
| Rp (Standard deviation) | 17.7 (8.2) |

**Base Film 4**

The procedure for Base Film 2 was followed and the resulting film then coated off-line with a planarising hardcoat layer comprising a UV-cured butyl acrylate at a thickness of 4.0 $\mu$m $\pm$ 0.2 $\mu$m.

**Base Films 5, 6 and 7**

The procedure for Base Film 2 was followed except that the aqueous primer coating composition had the following solids composition:

(i) Acrylic polymer (AC201 ®; Rohm and Haas);
(ii) Ammonium nitrate;
(iii) Colloidal silica; and
(iv) Surfactant/emulsifier (fatty ester: $RCO(OCH_2CH_2)_nOCH_3$).

The resulting film was then coated off-line with a second (planarising) coating composition identical to that used to make Base Film 4 to thicknesses of 1.9 $\mu$m $\pm$ 0.2 $\mu$m (for Base Film 5), 2.5 $\mu$m $\pm$ 0.2 $\mu$m (for Base Film 6) and 4.5 $\mu$m $\pm$ 0.2 $\mu$m (for Base Film 7).
Base Films 1 to 7 were then coated with a silicon dioxide barrier layer of 100nm in thickness, according to the method set out below, to yield composite films referred to hereinafter as Reference Example 1, Reference Example 2, Example 1, Example 2, Example 3, Example 4 and Example 5, respectively.
The barrier layer was applied by placing each Base Film in a stainless steel chamber, evacuated to a pressure of less than $10^{-6}$ torr and subjected to a 5 minute plasma pre-treatment in argon gas at a pressure of 3 millitorr. Microwave-assisted pulsed DC reactive magnetron sputtering is used to deposit thin film coatings of $SiO_2$ onto a polymer substrate held on the circumference of a rotating drum which passes repeatedly in front of a sputtered target of silicon and an oxygen-rich microwave plasma. The stoichiometry of the deposited film and its mechanical and optical properties are optimised and consistency ensured by control of the process parameters. The preferred process parameters are:

(i) Initial pressure: no greater than $10^{-6}$ torr;
(ii) Working pressure: 3 millitorr;
(ii) Sputtering gas: argon;
(iii) Reactive gas: Oxygen;
(iv) Target: boron-doped silicon target (rectangular target of approximate size 38 x 13 cm; manufactured by SCI Engineering Materials, Columbus, Ohio, US);
(v) DC power: 4.5kW
(vi) Microwave Power: 2.5kW.

The barrier properties of the Examples were tested in the calcium permeability test described herein, and the results (see Table 2) reported in terms of the lifetime (in hours) for the optical transmission to fall to 50% of the original value (i.e. t = 0 hours).

**Table 2 - barrier properties**

| FILM SAMPLE | Lifetime (hours) |
|---|---|
| Reference Example 1 | 16 |
| Reference Example 2 | 16 |
| Example 1 | >1000 |
| Example 2 | 48 |

(continued)

| FILM SAMPLE | Lifetime (hours) |
| --- | --- |
| Example 3 | >1000 |
| Example 4 | >1000 |
| Example 5 | >1000 |

The composite films of Examples 1, 3, 4 and 5 exhibit excellent barrier properties, which are significantly greater than those of the film of Reference Examples 1 or 2, in which the barrier layer was applied directly onto non-planarised substrates (in the case of Reference Example 1 onto an unprimed surface, and in the case of Reference Example 2 onto a primed surface). The composite films of Examples 1, 3, 4 and 5 also exhibit surprisingly superior barrier properties when compared to the film of Example 2.

The data show that the silicon dioxide layer applied as described herein provides an effective barrier layer when used in combination with a planarising layer. The data also show a surprisingly effective barrier performance when the silicon dioxide layer is used in combination with the preferred planarising layer described herein.

Example 1 was repeated using $Al_2O_3$, AlN, $ZrO_2$ or $Si_3N_4$ as the inorganic barrier layer, and good barrier properties were observed.

**Claims**

**1.** A method of manufacture of a composite film which comprises the steps of:

(i) forming a polymeric substrate layer;
(ii) stretching the substrate layer in at least one direction;
(iii) heat-setting under dimensional restraint at a tension in the range of about 19 to about 75 kg/m of film width, at a temperature above the glass, transition temperature of the polymer of the substrate layer but below the melting temperature thereof;
(iv) heat-stabilising the film at a temperature above the glass transition temperature of the polymer of the substrate layer but below the melting temperature thereof;
(v) applying a planarising coating composition such that the surface of said coated substrate exhibits a roughness average (Ra) value of less than 0.7 nm, and/or a root mean square roughness (Rq) value of less than 0.9 nm; and **characterised by**
(vi) providing an inorganic barrier layer of thickness from 2 to 1000nm by microwave-activated reactive magnetron sputtering.

**2.** A method according to claim 1 wherein said microwave-activated reactive magnetron sputtering is microwave-assisted pulsed DC reactive magnetron sputtering.

**3.** A method according to claim 1 or 2 wherein step (vi) further comprises a plasma pre-treatment of the planarised substrate prior to deposition of the barrier layer.

**4.** A method according to claim 3 wherein said plasma pre-treatment is microwave-activated.

**5.** A method according to claims 3 or 4 wherein prior to the deposition of the inorganic barrier layer, the planarised substrate is subjected to a plasma pre-treatment for a period of between about 2 and 8 minutes.

**6.** A method according to any of claims 1 to 5 wherein the sputtering gas is argon, the initial pressure is no greater than $10^{-6}$ torr, and the working pressure is in the range of 2 to 5 millitorr.

**7.** The method of any preceding claim wherein the planarising coating composition comprises polysiloxane.

**8.** The method of any preceding claim wherein the planarising coating composition is derived from:

(a) from about 5 to about 50 weight percent solids, the solids comprising from about 10 to about 70 weight percent silica and from about 90 to about 30 weight percent of a partially polymerized organic silanol of the general formula RSi(OH)$_3$,
wherein R is selected from methyl and up to about 40% of a group selected from the group consisting of vinyl, phenyl, gamma-glycidoxypropyl, and gamma-methacryloxypropyl, and
(b) from about 95 to about 50 weight percent solvent, the solvent comprising from about 10 to about 90 weight percent water and from about 90 to about 10 weight percent lower aliphatic alcohol,

wherein the coating composition has a pH of from about 3.0 to about 8.0.

9. A method according to claim 8 wherein the silica is colloidal silica having a particle size of from about 5 to about 25 nm.

10. A method according to claim 8 or 9 wherein the pH of the coating composition is in the range 3.0 to 6.5.

11. The method of any preceding claim wherein said polymeric substrate is derived from poly(ethylene naphthalate) or poly(ethylene terephthalate).

12. The method according to any preceding claim wherein the polymeric substrate is derived from 2,6-naphthalenedicarboxylic acid.

13. The method according to claim 11 or 12 wherein the poly(ethylene naphthalate) has an intrinsic viscosity of 0.5-1.5.

14. The method of any preceding claim wherein the composite film exhibits a water vapour transmission rate (WVTR) of less than $10^{-3}$g/m$^2$/day.

15. The method of claim 15 wherein the composite film exhibits a water vapour transmission rate (WVTR) of less than $10^{-6}$g/m$^2$/day.

16. The method of any preceding claim wherein the composite film exhibits a oxygen transmission rate (OTR) of less than $10^{-3}$mL/m$^2$/day.

17. The method of any preceding claim wherein the polymeric substrate of the composite film has a shrinkage at 30 minutes at 230°C of less than 1%.

18. The method of any preceding claim wherein the polymeric substrate of the composite film has a residual dimensional change $\Delta L_r$ measured at 25°C before and after heating the film from 8°C to 200°C and then cooling to 8°C, of less than 0.75% of the original dimension.

19. The method of any preceding claim wherein the polymeric substrate of the composite film is a heat-stabilised, heat-set, oriented film comprising poly(ethylene naphthalate) film having a coefficient of linear thermal expansion (CLTE) within the temperature range from -40 °C to +100 °C of less than $40\times10^{-6}$/°C.

20. The method according to any preceding claim wherein the composite film has a % of scattered visible light (haze) of <1.5%.

21. The method according to any preceding claim wherein the substrate is biaxially oriented.

22. The method according to any preceding claim wherein the surface of the planarised coated substrate exhibits an Ra value of less than 0.6 nm, and/or an Rq value of less than 0.8 nm.

23. The method according to any preceding claim wherein the composite film has a shrinkage at 30 minutes at 150°C of no more than 0.01%.

24. The method according to any preceding claim wherein the inorganic barrier layer comprises silicon dioxide.

25. A method for the manufacture of an electronic or opto-electronic device, said method comprising the method of claim 1 and furthermore comprising the method step (vii) of providing the composite film comprising said polymeric substrate layer, said planarising coating layer and said inorganic barrier layer as a substrate in said electronic or opto-electronic device.

26. The method according to claim 25 wherein the application of the barrier layer is as defined in any of claims 2 to 6.

27. The method according to any preceding claim further comprising providing an electrode layer by applying a conductive material onto at least part of the surface of the inorganic barrier layer.

**Patentansprüche**

1. Verfahren zur Herstellung einer Verbundfolie, welches die Schritte umfaßt:

   (i) Erzeugen einer polymeren Substratschicht,
   (ii) Verstrecken der Substratschicht in mindestens eine Richtung,
   (iii) Wärmefixieren unter dimensionaler Einschränkung bei einer Spannung im Bereich von etwa 19 bis etwa 75 kg/m Folienbreite bei einer Temperatur über der Glasübergangstemperatur des Polymers der Substratschicht, jedoch unter dessen Schmelztemperatur,
   (iv) Wärmestabilisieren der Folie bei einer Temperatur über der Glasübergangstemperatur des Polymers der Substratschicht, jedoch unter dessen Schmelztemperatur,
   (v) Aufbringen einer planarisierenden Beschichtungszusammensetzung, so daß die Oberfläche des beschichteten Substrats einen mittleren Rauheitswert (Ra) von weniger als 0,7 nm und/oder einen Quadratmittel-Rauheitswert (Rq) von weniger als 0,9 nm zeigt,
   und **gekennzeichnet ist durch**
   (vi) Bereitstellen einer anorganischen Sperrschicht einer Dicke von 2 bis 1000 nm **durch** Mikrowellen-aktiviertes, reaktives Magnetron-Sputtering.

2. Verfahren nach Anspruch 1, wobei das Mikrowellen-aktivierte, reaktive Magnetron-Sputtering Mikrowellen-gestütztes, gepulstes, reaktives DC-Magnetron-Sputtering ist.

3. Verfahren nach Anspruch 1 oder 2, wobei Schritt (vi) weiter eine Plasmavorbehandlung des planarisierten Substrats vor Ablagerung der Sperrschicht umfaßt.

4. Verfahren nach Anspruch 3, wobei die Plasmavorbehandlung Mikrowellenaktiviert ist.

5. Verfahren nach Anspruch 3 oder 4, wobei vor der Ablagerung der anorganischen Sperrschicht das planarisierte Substrat einer Plasmavorbehandlung für einen Zeitraum von zwischen etwa 2 und 8 Minuten unterzogen wird.

6. Verfahren nach einem der Ansprüche 1 bis 5, wobei das Sputter-Gas Argon ist, der anfängliche Druck nicht größer als $10^{-6}$ Torr ist und der Arbeitsdruck im Bereich von 2 bis 5 Millitorr liegt.

7. Verfahren nach einem der vorstehenden Ansprüche, wobei die planarisierende Beschichtungszusammensetzung Polysiloxan umfaßt.

8. Verfahren nach einem der vorstehenden Ansprüche, wobei die planarisierende Beschichtungszusammensetzung abgeleitet ist aus:

   (a) von etwa 5 bis etwa 50 Gew.-% Feststoffen, wobei die Feststoffe von etwa 10 bis etwa 70 Gew.-% Siliciumdioxid und von etwa 90 bis etwa 30 Gew.% eines teilweise polymerisierten organischen Silanols der allgemeinen Formel $RSi(OH)_3$ umfassen, wobei R ausgewählt ist aus Methyl und bis zu etwa 40% einer Gruppe, ausgewählt aus der Gruppe, bestehend aus Vinyl, Phenyl, gamma-Glycidoxypropyl und gamma-Methacryloxypropyl und
   (b) von etwa 95 bis etwa 50 Gew.-% Lösungsmittel, wobei das Lösungsmittel von etwa 10 bis etwa 90 Prozent Wasser und von etwa 90 bis etwa 10 Gew.-% eines niederen aliphatischen Alkohols umfaßt,

   wobei die Beschichtungszusammensetzung einen pH-Wert von etwa 3,0 bis etwa 8,0 aufweist.

9. Verfahren nach Anspruch 8, wobei das Siliciumdioxid kolloidales Siliciumdioxid ist, das eine Teilchengröße von etwa 5 bis etwa 25 nm aufweist.

10. Verfahren nach Anspruch 8 oder 9, wobei der pH-Wert der Beschichtungszusammensetzung im Bereich von 3,0 bis 6,5 liegt.

11. Verfahren nach einem der vorstehenden Ansprüche, wobei das polymere Substrat von Poly(ethylennaphthalat) oder Poly(ethylenterephthalat) abgeleitet ist.

12. Verfahren nach einem der vorstehenden Ansprüche, wobei das polymere Substrat von 2,6-Naphthalindicarbonsäure abgeleitet ist.

13. Verfahren nach Anspruch 11 oder 12, wobei das Poly(ethylennaphthalat) eine innere Viskosität von 0,5 bis 1,5 aufweist.

14. Verfahren nach einem der vorstehenden Ansprüche, wobei die Verbundfolie eine Wasserdampf-Transmissionsrate (*water vapour transmission rate,* WVTR) von weniger als $10^{-3}$ g/m$^2$/Tag zeigt.

15. Verfahren nach Anspruch 14, wobei die Verbundfolie eine Wasserdampf-Transmissionsrate (WVTR) von weniger als $10^{-6}$g/m$^2$/Tag zeigt.

16. Verfahren nach einem der vorstehenden Ansprüche, wobei die Verbundfolie eine Sauerstoff-Transmissionsrate (*oxygen transmission rate,* OTR) von weniger als $10^{-3}$ mL/m$^2$/Tag zeigt.

17. Verfahren nach einem der vorstehenden Ansprüche, wobei das polymere Substrat der Verbundfolie eine Schrumpfung bei 30 Minuten bei 230°C von weniger als 1% aufweist.

18. Verfahren nach einem der vorstehenden Ansprüche, wobei das polymere Substrat der Verbundfolie eine Rest-Dimensionsveränderung $\Delta L_r$, gemessen bei 25°C vor und nach Erhitzen der Folie von 8°C auf 200°C und folgendem Abkühlen auf 8°C, von weniger als 0,75% der ursprünglichen Dimension aufweist.

19. Verfahren nach einem der vorstehenden Ansprüche, wobei das polymere Substrat der Verbundfolie eine wärmestabilisierte, wärmefixierte, orientierte Folie ist, umfassend Poly(ethylennaphthalat)-Folie, die einen linearen Wärmeausdehnungskoeffizienten (*coefficient of linear thermal expansion,* CLTE) im Temperaturbereich von -40°C bis +100°C von weniger als 40 x $10^{-6}$/°C aufweist.

20. Verfahren nach einem der vorstehenden Ansprüche, wobei die Verbundfolie einen Prozentsatz von gestreutem sichtbaren Licht (Trübung) von < 1,5% aufweist.

21. Verfahren nach einem der vorstehenden Ansprüche, wobei das Substrat biaxial orientiert ist.

22. Verfahren nach einem der vorstehenden Ansprüche, wobei die Oberfläche des planarisierten, beschichteten Substrats einen Ra-Wert von weniger als 0,6 nm und/oder einen Rq-Wert von weniger als 0,8 nm zeigt.

23. Verfahren nach einem der vorstehenden Ansprüche, wobei die Verbundfolie eine Schrumpfung bei 30 Minuten bei 150°C von nicht mehr als 0,01% aufweist.

24. Verfahren nach einem der vorstehenden Ansprüche, wobei die anorganische Sperrschicht Siliziumdioxid umfaßt.

25. Verfahren zur Herstellung einer elektronischen oder optoelektronischen Vorrichtung, wobei das Verfahren das Verfahren nach Anspruch 1 umfaßt und weiter den Verfahrensschritt

(vii) des Bereitstellens der Verbundfolie, umfassend die polymere Substratschicht, die planarisierte Beschichtungsschicht und die anorganische Sperrschicht als Substrat in der elektronischen oder optoelektronischen Vorrichtung

umfaßt.

26. Verfahren nach Anspruch 25, wobei das Aufbringen der Sperrschicht wie in einem der Ansprüche 2 bis 6 definiert ist.

27. Verfahren nach einem der vorstehenden Ansprüche, weiter umfassend das Bereitstellen einer Elektrodenschicht durch Aufbringen eines leitfähigen Materials auf mindestens einen Teil der Oberfläche der anorganischen Sperrschicht.

## Revendications

**1.** Procédé de fabrication d'un film composite, comprenant les étapes suivantes :

(i) former une couche de substrat polymérique ;
(ii) étirer la couche de substrat dans au moins une direction ;
(iii) thermofixation sous contrainte dimensionnelle à une traction comprise entre environ 19 et environ 75 kg/m de largeur de film, à une température supérieure à la température de transition vitreuse du polymère de la couche de substrat mais inférieure à la température de fusion de celui-ci ;
(iv) stabiliser thermiquement le film à une température supérieure à la température de transition vitreuse du polymère de la couche de substrat mais inférieure à la température de fusion de celui-ci ;
(v) appliquer une composition de revêtement de planarisation telle que la surface dudit substrat revêtu présente une valeur de rugosité moyenne (Ra) inférieure à 0,7 nm et/ou une valeur de rugosité quadratique moyenne (Rq) inférieure à 0,9 nm ; et **caractérisé par** le fait de
(vi) prévoir une couche barrière inorganique d'une épaisseur comprise entre 2 et 1000nm par pulvérisation magnétron réactive activée par micro-ondes.

**2.** Procédé selon la revendication 1, dans lequel ladite pulvérisation magnétron réactive activée par micro-ondes est une pulvérisation magnétron réactive à courant continu pulsé assistée par micro-ondes.

**3.** Procédé selon la revendication 1 ou 2, dans lequel l'étape (vi) comprend, en outre, un prétraitement par plasma du substrat planarisé avant dépôt de la couche barrière.

**4.** Procédé selon la revendication 3, dans lequel ledit prétraitement par plasma est activé par micro-ondes.

**5.** Procédé selon la revendication 3 ou 4, dans lequel, avant dépôt de la couche barrière inorganique, le substrat planarisé est soumis à un prétraitement par plasma d'une durée comprise entre environ 2 et 8 minutes.

**6.** Procédé selon l'une quelconque des revendications 1 à 5, dans lequel le gaz de pulvérisation est de l'argon, la pression initiale n'est pas supérieure à $10^{-6}$ torr et la pression de service est comprise entre 2 et 5 millitorr.

**7.** Procédé selon l'une quelconque des revendications précédentes, dans lequel la composition de revêtement de planarisation comprend du polysiloxane.

**8.** Procédé selon l'une quelconque des revendications précédentes, dans lequel la composition de revêtement de planarisation est à base de :

(a) environ 5 à environ 50 pourcent en poids de solides, les solides comprenant d'environ 10 à environ 70 pourcent en poids de silice et d'environ 90 à environ 30 pourcent en poids d'un silanol organique partiellement polymérisé de la formule générale $RSi(OH)_3$, R étant sélectionné parmi le méthyl et jusqu'à environ 40% d'un groupe choisi dans le groupe constitué de vinyle, phényl, gamma-glycidoxypropyl et gamma-méthacryloxypropyl, et
(b) environ 95 à environ 50 pourcent en poids de solvant, le solvant comprenant d'environ 10 à environ 90 pourcent en poids d'eau et d'environ 90 à environ 10 pourcent en poids d'alcool aliphatique inférieur, la composition de revêtement ayant un pH compris entre environ 3,0 et environ 8,0.

**9.** Procédé selon la revendication 8, dans lequel la silice est une silice colloïdale dont la taille particulaire est de l'ordre de 5 à 25 nm.

**10.** Procédé selon la revendication 8 ou 9, dans lequel le pH de la composition de revêtement se situe dans la plage de 3,0 à 6,5.

**11.** Procédé selon l'une quelconque des revendications précédentes, dans lequel ledit substrat polymérique est dérivé du poly(éthylène naphtalate) ou poly(éthylène téréphtalate).

**12.** Procédé selon l'une quelconque des revendications précédentes, dans lequel le substrat polymérique est dérivé de l'acide 2,6-naphtalènedicarboxylique.

**13.** Procédé selon la revendication 11 ou 12, dans lequel le poly(éthylène naphtalate) a une viscosité intrinsèque de 0,5 - 1,5.

**14.** Procédé selon l'une quelconque des revendications précédentes, dans lequel le film composite présente un taux de transmission de vapeur d'eau (WVTR) inférieur à $10^{-3}$g/m$^2$/jour.

**15.** Procédé selon la revendication 14, dans lequel le film composite présente un taux de transmission de vapeur d'eau (WVTR) inférieur à $10^{-6}$g/m$^2$/jour.

**16.** Procédé selon l'une quelconque des revendications précédentes, dans lequel le film composite présente un taux de transmission de l'oxygène (OTR) inférieur à $10^{-3}$mL/m$^2$/jour.

**17.** Procédé selon l'une quelconque des revendications précédentes, dans lequel le substrat polymérique du film composite présente un retrait à 30 minutes à 230°C inférieur à 1%.

**18.** Procédé selon l'une quelconque des revendications précédentes, dans lequel le substrat polymérique du film composite présente un taux de changement dimensionnel résiduel $\Delta L_r$ mesuré à 25°C avant et après chauffage du film à une température de 8°C à 200°C, puis refroidissement à 8°C, qui est inférieur à 0,75 % de la dimension d'origine.

**19.** Procédé selon l'une quelconque des revendications précédentes, dans lequel le substrat polymérique du film composite est un film stabilisé thermiquement, thermofixé, orienté comprenant un film de poly(éthylène naphtalate) à coefficient de dilatation thermique linéaire (CLTE), dans la plage de température de -40°C à +100°C, inférieur à $40 \times 10^{-6}$/°C.

**20.** Procédé selon l'une quelconque des revendications précédentes, dans lequel le film composite a un % de lumière visible dispersée (voile) <1,5%.

**21.** Procédé selon l'une quelconque des revendications précédentes, dans lequel le substrat est orienté biaxialement.

**22.** Procédé selon l'une quelconque des revendications précédentes, dans lequel la surface du substrat revêtu planarisé présente une valeur Ra inférieure à 0,6 nm et/ou une valeur Rq inférieure à 0,8 nm.

**23.** Procédé selon l'une quelconque des revendications précédentes, dans lequel le film composite présente un retrait à 30 minutes à 150°C n'excédant pas 0,01%.

**24.** Procédé selon l'une quelconque des revendications précédentes, dans lequel la couche barrière inorganique comprend du bioxyde de silicium.

**25.** Procédé de fabrication d'un dispositif électronique ou opto-électronique, ledit procédé comprenant le procédé selon la revendication 1 et comprenant, en outre, l'étape de procédé consistant à :

(vii) prévoir le film composite comprenant ladite couche de substrat polymérique, ladite couche de revêtement de planarisation et ladite couche barrière inorganique en tant que substrat dans ledit dispositif électronique ou opto-électronique.

**26.** Procédé selon la revendication 25, dans lequel l'application de la couche barrière est telle que définie dans l'une quelconque des revendications 2 à 6.

**27.** Procédé selon l'une quelconque des revendications précédentes, consistant, en outre, à prévoir une couche d'électrode en appliquant un matériau conducteur sur au moins une partie de la surface de la couche barrière inorganique.

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4720432 A
- US 6198217 B
- WO 0322575 A
- WO 0387247 A
- EP 0419400 A
- EP 0429179 A
- EP 0408197 A
- US 3443950 A
- US 5069942 A
- US 5415942 A
- WO 02079757 A
- JP 6116487 A
- JP 63037167 A

**Non-patent literature cited in the description**

- **W. J. Feast.** *Polymer,* 1996, vol. 37 (22), 5017-5047
- Veeco Process Metrology. June 1998
- **G. Nisato ; M Kuilder ; P. Bouten ; L Moro ; O. Philips ; N. Rutherford.** *Society For Information Display, Digest of Technical Papers,* 2003, 550-553
- **Pulker, H.K. ; Schlichtherle, S.** Density related properties of metal oxide films. *Proc SPIE 5250, Advances in Optical Thin Films,* 2004, 1-11
- **H.A. MacLeod.** Thin Film Optical Filters. Bristol and Philadelphia: Institute of Physics Publishing, 2001